# EUROPEAN PATENT SPECIFICATION

(11) **EP 0 959 559 B1**
(45) Date of publication and mention of the grant of the patent: **14.07.2004**
(21) Application number: 99303816.5
(22) Date of filing: 17.05.1999
(51) Int. Cl.: H03D 7/16

(54) **Direct broadcast satellite tuner**
Direktrundfunkübertragungssatellitenempfänger
Dispositif d'accord pour récepteur de diffusion directe par satellite

(30) Priority: 22.05.1998 JP 14104498
(43) Date of publication of application: 24.11.1999
(73) Proprietor: Sharp Kabushiki Kaisha, Osaka-shi, Osaka 545-8522 (JP)
(72) Inventor: Ikemoto, Tetsuya, Osaka-shi, Osaka (JP); Inoue, Kenichi, Matsubara-shi, Osaka (JP)
(74) Representative: Brown, Kenneth Richard

(56) References cited:
- EP-A- 0 766 418
- EP-A- 0 777 335

## Description

### BACKGROUND OF THE INVENTION

### Field of the Invention

The present invention relates to a DBS (direct broadcast by satellite) tuner for receiving analog and digital satellite broadcast.

### Description of the Prior Art

Conventionally, reception of both analog-signal-based and digital-signal-based satellite broadcast is achieved, for satellite broadcast carried by an FM (frequency-modulated) analog signal, by receiving it by the use of an analog-signal receiver, and, for satellite broadcast carried by a QPSK-modulated digital signal, by receiving it by the use of a digital-signal receiver; that is, it is necessary to use two set-top boxes in total, or alternatively a TV (television) receiver incorporating two tuners corresponding thereto.

In Europe, where digital-signal-based satellite broadcast is in the process of being spread and thus digital and analog satellite broadcast coexists, there is a need for a set-top box that can receive both analog and digital satellite broadcast. To satisfy this requirement, a tuner has been proposed that can receive both analog and digital satellite broadcast. A tuner of this type is known e.g. from EP-A-777 335.

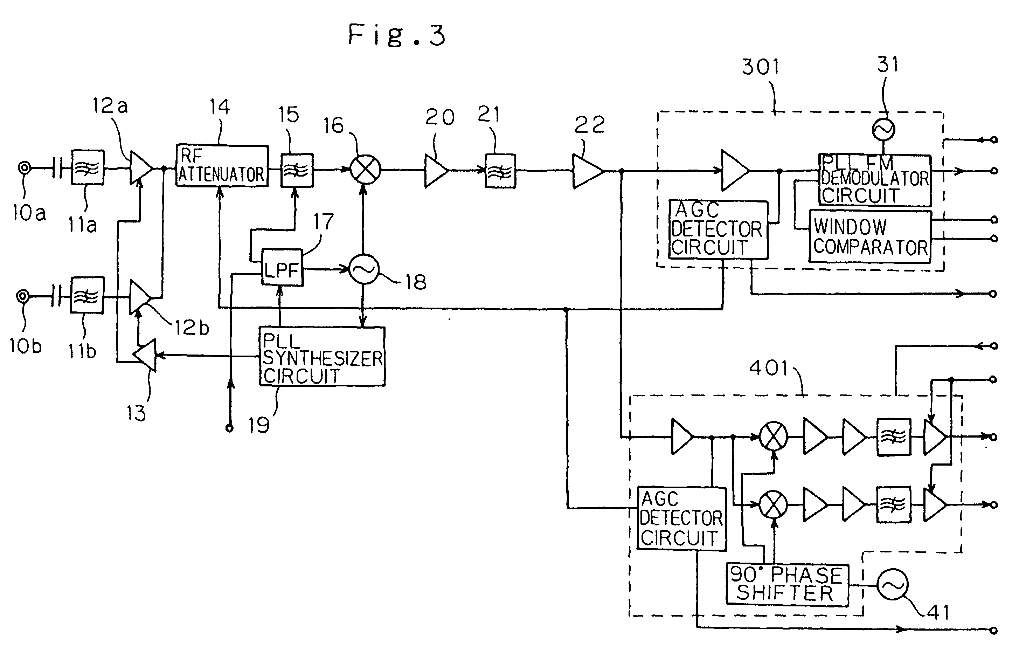

Now, a conventional example will be described. Fig. 3 is a block diagram of a conventional DBS (direct broadcast by satellite) tuner for receiving satellite broadcast by receiving a QPSK-modulated digital signal and an FM (frequency modulated) analog signal. As shown in Fig. 3, two RF signals are fed in to the tuner via input terminals 10a and 10b, respectively, and are then delivered individually to RF circuits each consisting of a high-pass filter 11a or 11b and an RF amplifier circuit 12a or 12b. One of these two RF amplifier circuits 12a and 12b is selected for activation at a time by a switching circuit 13 composed of transistors.

One of the two RF signals fed in to the tuner via the input terminals 10a and 10b is selected by the above-mentioned switching circuit 13, is then amplified by the RF amplifier circuit 12a or 12b, and is then subjected to level adjustment by an attenuator 14 that is common to the two signals. After level adjustment, the RF signal is subjected to pass band adjustment by an RF band-pass filter 15, is then mixed by a mixer 16 with a local oscillation signal fed from a local oscillation circuit 18 controlled by a PLL synthesizer circuit 19 and an LPF (low-pass filter) 17, and is thereby converted into an IF (intermediate-frequency) signal having a frequency of, for example, 479.5 MHz.

The IF signal thus obtained by frequency conversion is then amplified by an IF amplifier circuit 20, is then passed through an IF band-pass filter 21, is then further amplified by an IF amplifier circuit 22, and is then divided into two signals. One of the signals thus obtained by division is fed to an FM demodulator 301, where the signal is subjected to FM demodulation to produce an FM detected signal. The other of the signals obtained by division after amplification by the IF amplifier circuit 22 is fed to an I/Q converter 401, where the signal is subjected to frequency conversion so as to be converted into a base band signal to produce two signals, called the *I* and *Q* signals, having a phase difference of 90 degrees with respect to each other.

In the conventional DBS tuner for receiving satellite broadcast described above, cost reduction can be achieved by miniaturization and by reducing the number of constituent components as achieved by component sharing. In the conventional example described above, the front-end portion of the tuner including the RF amplifier circuit 12a, the RF attenuator 14, the RF band-pass filter 15, the mixer 16, the first local oscillation circuit 18, the PLL synthesizer circuit 19, and the IF amplifier circuit 20, and the IF amplifier portion including the band-pass filter 21 are common to analog and digital signals, and thus their basic circuit design can be shared between analog and digital signals. On the other hand, the I/Q converter 401 used to achieve QPSK demodulation of the digital signal and the FM demodulator 301 used to achieve FM demodulation of the analog signal are required separately.

In general, the I/Q converter 401 uses an oscillation circuit 41 having a resonator (for example, a SAW resonator) that resonates at 479.5 MHz (or 402.78 MHz), and the FM demodulator 301 uses a VCO (voltage-controlled oscillator) 31 that oscillates near (i.e. not exactly at) 479.5 MHz (or 402.78 MHz) (the FM demodulator minimizes the noise occurring when the C/N ratio is low by shifting the oscillation frequency of the VCO). If these two oscillation circuits are placed close to each other within the same chassis, their oscillation frequencies, very close to each other, tend to cause spurious oscillation and pulling of the oscillation frequency. In particular, if the VCO 41 of the I/Q converter 401, provided for the processing of a digitally modulated signal, is affected by the VCO 31 of the FM demodulator 301, the phase noise in the I/Q converter increases, and thus the overall phase noise throughout the tuner increases, degrading the bit error rate after QPSK demodulation in the QPSK demodulation circuit (not shown) placed in the stage succeeding to the DBS tuner. Of the FM demodulator 301 and the I/Q converter 401, only one is selected for activation at a time, and the other is brought into an inactive state. However, when the signal type is switched (i.e. when the tuner is switched from the state for receiving an FM signal to the state for receiving a QPSK signal), there occurs a time period (a short time period) in which both become active momentarily, and the above problem occurs during this time period.

### SUMMARY OF THE INVENTION

An object of the present invention is to miniaturize a tuner for receiving satellite broadcast having an FM modulator and an I/Q converter arranged within a single chassis and to reduce the mutual interference between the FM modulator and the I/Q converter in such a tuner.

To achieve the above object, according to the present invention as defined in Claim 1, in a DBS tuner that receives satellite broadcast by receiving a QPSK modulated digital signal and an FM (frequency modulated) analog signal, the tuner sharing a highfrequency signal processing circuit provided in a front-end portion for receiving an RF (radio frequency) signal having a frequency around 1 to 2 GHz and an intermediate frequency amplifier portion including an intermediate frequency amplifier circuit for amplifying a signal obtained by converting a received signal to an intermediate frequency and a band-pass filter, the tuner having an I/Q converter for processing a modulated digital signal output from the band-pass filter and an FM demodulator for processing an FM analog signal output from the band-pass filter, amplifier circuits are provided between the output side of the band-pass filter and the input side of the FM demodulator and between the output side of the band-pass filter and the input side of the I/Q converter.

As described above, amplifier circuits are provided in the stage following the output of the band-pass filter both on the input side of the FM demodulator and on the input side of the I/Q converter. This helps improve the isolation between the signal paths to the FM demodulator and to the I/Q converter and thereby reduce the interference between the oscillation circuits of the FM demodulator and the I/Q converter. In this way, it is possible to reduce the effect of the signal returning along the signal path from the I/Q converter to the FM demodulator and of the signal returning along the signal path from the FM demodulator to the I/Q converter. In particular, this is effective in reducing the phase noise occurring in the VCO of the I/Q converter.

Moreover, within the chassis of the DBS tuner for receiving satellite broadcast, the intermediate frequency amplifier circuit is placed between the FM demodulator and the I/Q converter. This makes it possible to reduce the spatial interference between the oscillation circuits of the FM demodulator and the I/Q converter by the use of a chassis of a relatively small volume.

### BRIEF DESCRIPTION OF THE DRAWINGS

This and other objects and features of the present invention will become clear from the following description, taken in conjunction with the preferred embodiments with reference to the accompanying drawings in which:
Fig. 1 is a block diagram showing the circuit configuration of a DBS tuner for receiving satellite broadcast according to the invention;
Fig. 2 is a diagram showing the structure of the chassis of the DBS tuner for receiving satellite broadcast according to the invention; and
Fig. 3 is a block diagram showing the circuit configuration of a conventional example.

### DESCRIPTION OF THE PREFERRED EMBODIMENTS

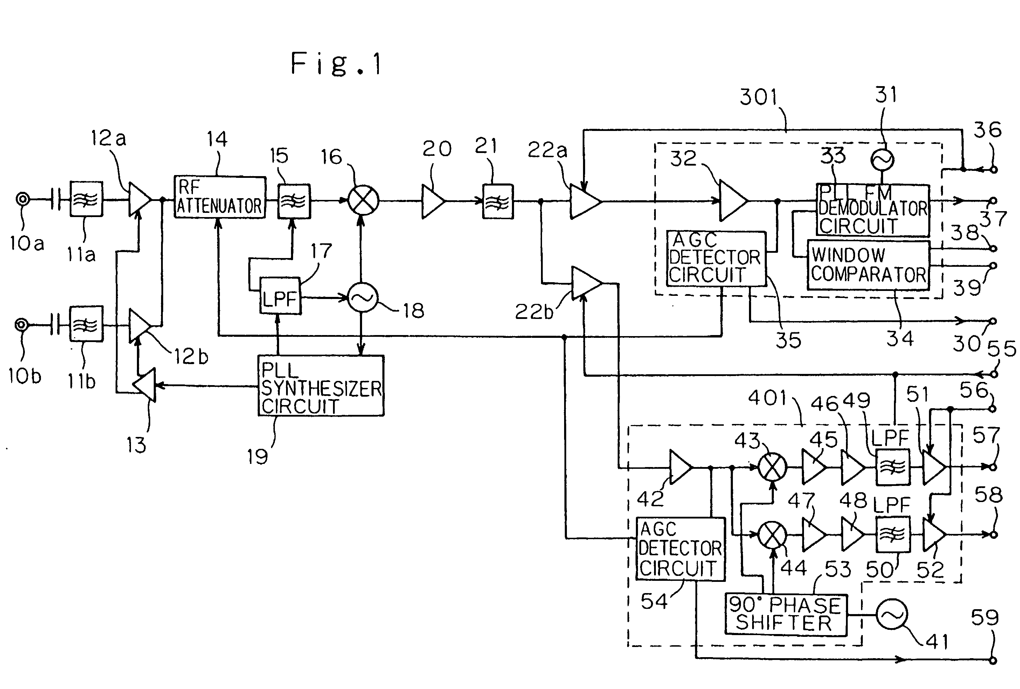

Hereinafter, an embodiment of the present invention will be described with reference to the accompanying drawings. Fig. 1 is a block diagram showing the circuit configuration of a DBS tuner for receiving satellite broadcast according to the invention. In Fig. 1, such components as are found also in the conventional example shown in Fig. 3 are identified with the same reference numerals and symbols.

In Fig. 1, two RF signals are fed in to the tuner via input terminals 10a and 10b, respectively, and are then delivered individually to RF circuits each consisting of a high-pass filter 11a or 11b and an RF amplifier circuit 12a or 12b. One of these two RF amplifier circuits 12a and 12b is selected for activation at a time by a switching circuit 13 composed of transistors.

The two RF signals fed in to the tuner via the input terminals 10a and 10b are amplified by one of the RF amplifier circuits 12a and 12b as selected by the above-mentioned switching circuit 13, and is then subjected to level adjustment by an attenuator 14 that is common to the two signals. After level adjustment, the RF signal is passed through an RF band-pass filter 15, is then mixed by a mixer 16 with a local oscillation signal fed from a local oscillation circuit 18 controlled by a PLL synthesizer circuit 19 and an LPF (low-pass filter) 17, and is thereby converted into an IF (intermediate-frequency) signal having a frequency of, for example, 479.5 MHz.

The IF signal thus obtained by frequency conversion is then amplified by an IF amplifier circuit 20, is then passed through an IF band-pass filter 21, and is then divided into two signals, which are fed to IF amplifier circuits 22a and 22b. The IF signal amplified by the IF amplifier circuit 22a is subjected to FM demodulation by an FM demodulator 301 to produce an FM detected signal. The IF signal amplified by the IF amplifier circuit 22b is subjected to frequency conversion by an I/Q converter 401 so as to be converted into a base band signal to produce two signals, called the *I* and *Q* signals, having a phase difference of 90 degrees with respect to each other. As described above, the output obtained from the band-pass filter 21 of the IF amplifier portion is divided into two signals that are amplified individually by the IF amplifier circuits 22a and 22b. This helps improve the isolation between the input to the FM demodulator 301 and the input to the I/Q converter 401 and thereby reduce the mutual effect between the I/Q converter 401 and the FM demodulator 301 caused by signals returning from the former to the latter and vice versa. In particular, this is effective in reducing the phase noise occurring in the VCO of the I/Q converter 401. The FM demodulator 301 and the I/Q converter 401 are each formed as an integrated circuit.

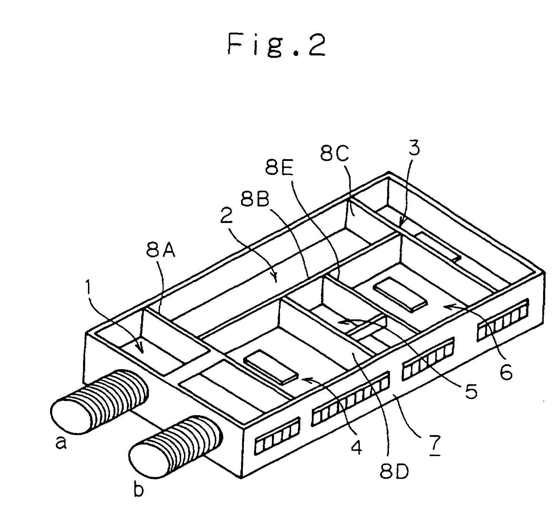

Fig. 2 is a diagram showing the arrangement of the individual circuit blocks within the chassis of the tuner according to the invention. In Fig. 2, reference numeral 1 represents a section for housing the circuit block of the RF amplifiers 12a and 12b; reference numeral 2 represents a section for housing the frequency conversion circuit block including the RF attenuator 14, the RF band-pass filter 15, and the mixer circuit 16; reference numeral 3 represents a section for housing the local oscillator circuit block including the local oscillator circuit 18 and the synthesizer circuit; reference numeral 4 represents a section for housing the circuit block of the FM demodulator 301; reference numeral 5 represents a section for housing the IF amplifier circuit block including the IF amplifier circuit 20 and the band-pass filter 21; reference numeral 6 represents a section for housing the circuit block of the I/Q converter circuit 401; and reference symbols a and b represent the first and second input terminals, respectively, of the DBS tuner for receiving satellite broadcast.

The above-mentioned circuit blocks 1 to 6 are formed within a metal chassis, and are shielded from one another by metal shields 8A to 8E. Moreover, as shown in Fig. 2, between the section 4 for housing the circuit block of the FM demodulator 301 and the section 6 for housing the circuit block of the I/Q converter circuit 401 is arranged the section 5 for housing the IF amplifier circuit block including the IF amplifier 20 and the band-pass filter 21 so that the section 4 for housing the circuit block of the FM demodulator 301 and the section 6 for housing the circuit block of the I/Q converter circuit 401 are isolated from each other with the section 5 for housing the IF amplifier circuit block arranged between them. According to this arrangement, it is possible to miniaturize the chassis of the tuner and, even then, ensure that the FM demodulator and the I/Q converter circuit are placed away from each other and shielded from each other. This helps prevent the two circuits from directly sharing a common ground line, and thereby reduce the adverse effect of the signals between the two circuits. In this case, it is possible to arrange both of the intermediate frequency amplifier circuits 22a and 22b in the section 5, or alternatively arrange the intermediate frequency amplifier circuit 22a in the section 4 and the intermediate frequency amplifier circuit 22b in the section 6.

Back in Fig. 1, the FM demodulator 301 is provided with an amplifier circuit 32, a PLL-type FM demodulator circuit 33, a window comparator 39, and an AGC detection circuit 35. Reference numeral 36 represents a terminal at which the FM demodulator 301 receives electric power. Reference numeral 37 represents an output terminal at which the FM demodulator 301 outputs the FM demodulated signal. Reference numerals 38 and 39 represent terminals at which the output of a widow comparator 34 is output as a first AFT (automatic fine tuning) signal and a second AFT signal. The AGC signal output from the AGC detection circuit 35 is fed to the RF attenuator 14 and also to an analog AGC terminal 30.

The I/Q converter 401 is provided with an amplifier 42, demodulators 43 and 44, amplifiers 45 to 48, low-pass filters 49 and 50, AGC amplifiers 51 and 52, a 90-degree phase shifter 53, and an AGC detection circuit 54. Reference numeral 55 represents a supplied power terminal at which the I/Q converter 401 receives electric power. Reference numeral 56 represents an AGC signal input terminal, reference numeral 57 represents an I signal output terminal, and reference numeral 58 represents a Q signal output terminal. The output of the AGC detection circuit 54 is fed to the attenuator 14 and also to a terminal 59.

The above-mentioned terminals 30, 37, 38, and 39 are connected to a circuit (not shown) that processes the FM demodulated signal. On the other hand, the above-mentioned terminals 57, 58, and 59 are connected to a circuit (not shown) that processes the I and Q signals.

## Claims

1. A direct broadcast by satellite, DBS, tuner having an RF circuit (11-19) for processing an RF signal (10a, 10b), an intermediate frequency amplifier portion including an intermediate frequency amplifier circuit (20) for amplifying a signal obtained by converting the RF signal to an intermediate frequency and a band-pass filter (21), an I/Q converter (401) for processing a modulated digital signal output from the band-pass filter, and an FM demodulator (301) for processing an FM modulated analog signal output from the band-pass filter
wherein a first intermediate frequency signal amplifier circuit (22a) is provided between an output side of the band-pass filter and an input side (32) of the FM demodulator and a separate second intermediate frequency signal amplifier circuit (22a) is provided between the output side of the band-pass filter (21) and an input side (42) of the I/Q converter.

2. A DBS tuner as claimed in claim 1,
wherein the intermediate frequency amplifier portion (20, 21), the FM demodulator (301), and the I/Q converter (401) are arranged in separate sections (5, 4, 6) secured inside a chassis (7) of the tuner and partitioned by shielding members (8A -8C).

3. A DBS tuner as claimed in claim 2,
wherein the intermediate frequency amplifier portion (5, 20, 21) is arranged between the I/Q converter (6,401) and the FM demodulator (4, 301).

## Patentansprüche

1. Tuner für Satelliten-Direktübertragung, DBS-Tuner, mit einer HF-Schaltung (11 - 19) zum Verarbeiten eines HF-Signals (10a, 10b), einem Zwischenfrequenzverstärker-Abschnitt mit einer Zwischenfrequenzverstärker-Schaltung (20) zum Verstärken eines Signals, das durch Wandeln des HF-Signals in eine Zwischenfrequenz erhalten wurde, und einem Bandpassfilter (21), einem I/Q-Wandler (401) zum Verarbeiten eines vom Bandpassfilter ausgegebenen modulierten digitalen Signals, und einem FM-Demodulator (301) zum Verarbeiten eines vom Bandpassfilter ausgegebenen FM-modulierten analogen Signals, - wobei zwischen der Ausgangsseite des Bandpassfilters und der Eingangsseite des FM-Demodulators eine erste Zwischenfrequenzsignal-Verstärkerschaltung (22a) vorhanden ist und eine gesonderte zweite Zwischenfrequenzsignal-Verstärkerschaltung (22b) zwischen der Ausgangsseite des Bandpassfilters (21) und der Eingangsseite (42) des I/Q-Wandlers vorhanden ist.

2. DBS-Tuner nach Anspruch 1, bei dem der Zwischenfrequenzverstärker-Abschnitt (20, 21), der FM-Demodulator (301) und der I/Q-Wandler (401) in gesonderten Abschnitten (5, 4, 6) angeordnet sind, die innerhalb eines Chassis des Tuners bereitgestellt sind und durch Abschirmelemente (8a - 8c) abgetrennt sind.

3. DBS-Tuner nach Anspruch 2, bei dem der Zwischenfrequenzverstärker-Abschnitt (5, 20, 21) zwischen dem FM-Demodulator (4, 301) und dem I/Q-Wandler (6, 401) angeordnet ist.

## Revendications

1. Syntoniseur de diffusion directe par satellite (DBS) comportant un circuit HF (11-19) destiné à traiter un signal HF (10a, 10b); une partie d'amplification à fréquence intermédiaire comprenant un circuit amplificateur à fréquence intermédiaire (20) destiné à amplifier un signal obtenu par la conversion du signal HF en une fréquence intermédiaire, et un filtre passe-bande (21); un convertisseur I/Q (401) destiné à traiter un signal numérique modulé délivré en sortie par le filtre passe-bande; et un démodulateur FM (301) destiné à traiter un signal analogique modulé FM délivré en sortie par le filtre passe-bande,
un premier circuit amplificateur de signal à fréquence intermédiaire (22a) étant prévu entre un côté sortie du filtre passe-bande et un côté entrée (32) du démodulateur FM, et un second circuit amplificateur de signal à fréquence intermédiaire séparé (22b) étant prévu entre le côté sortie du filtre passe-bande (21) et un côté entrée (42) du convertisseur I/Q.

2. Syntoniseur DBS tel que défini dans la revendication 1, dans lequel la partie d'amplification à fréquence intermédiaire (20, 21), le démodulateur FM (301) et le convertisseur I/Q (401) sont disposés dans des compartiments séparés (5, 4, 6) ménagés à l'intérieur d'un châssis (7) du syntoniseur et cloisonnés par des éléments de protection (8A-8C).

3. Syntoniseur DBS tel que défini dans la revendication 2, dans lequel la partie d'amplification à fréquence intermédiaire (5, 20, 21) est disposée entre le convertisseur I/Q (6, 401) et le démodulateur FM (4, 301).
